(19) **Europäisches Patentamt**
**European Patent Office**
**Office européen des brevets**

(11) **EP 2 091 305 B1**

(12) **EUROPEAN PATENT SPECIFICATION**

(45) Date of publication and mention
of the grant of the patent:
**23.01.2013  Bulletin 2013/04**

(51) Int Cl.:
***H05H 1/24*** (2006.01)

(21) Application number: **09250342.4**

(22) Date of filing: **11.02.2009**

(54) **Plasma reactor and plasma reaction apparatus**

Plasmareaktor und Plasmareaktionsvorrichtung

Réacteur à plasma et appareil pour réactions à plasma

(84) Designated Contracting States:
**DE FR GB**

(30) Priority: **14.02.2008   JP 2008033409**

(43) Date of publication of application:
**19.08.2009   Bulletin 2009/34**

(73) Proprietor: **NGK Insulators, Ltd.**
**Nagoya-City, Aichi Pref.  467-8530 (JP)**

(72) Inventors:
 • **Masuda, Masaaki**
 **Nagoya City,**
 **Aichi-ken, 467-8530 (JP)**

 • **Takahashi, Michio**
 **Nagoya City,**
 **Aichi-ken, 467-8530 (JP)**
 • **Mizuno, Hiroshi**
 **Nagoya City,**
 **Aichi-ken, 467-8530 (JP)**

(74) Representative: **Paget, Hugh Charles Edward et al**
**Mewburn Ellis LLP**
**33 Gutter Lane**
**London**
**EC2V 8AS (GB)**

(56) References cited:
**EP-A1- 1 643 093       JP-A- 2005 123 034**
**JP-A- 2005 268 129       JP-A- 2007 144 244**
**US-A1- 2007 221 633**

**Description**

BACKGROUND OF THE INVENTION

Field of the Invention

The present invention relates to an integrated plasma reactor that includes a plasma reaction section and a heat-supplying gas circulation section, the plasma reaction section allowing gas introduced between a pair of tabular electrodes to undergo a reaction by generating plasma, and a plasma reaction apparatus.

Description of Related Art

A silent discharge occurs when disposing a dielectric between a pair of tabular electrodes and applying a high alternating-current voltage or a periodic pulse voltage between the electrodes. Active species, radicals, and ions are produced in the resulting plasma field to promote a reaction and decomposition of gas. This phenomenon may be utilized to remove toxic components contained in engine exhaust gas or incinerator exhaust gas.

Technology that mixes hydrocarbon fuel and air, reforms the mixture using a catalyst, and supplies a reformed gas containing hydrogen to an internal combustion engine has been known (see JP-A-2006-265008, United States Patent No. 7,131,264, and United States Patent No. 7,240,483). Combustion that occurs in the internal combustion engine is promoted by utilizing a reformed gas containing hydrogen so that exhaust gas can be reduced.

US-A-2007/0221633 describes a plasma reactor having a plurality of unit electrodes layered in a stack with predetermined spacing and defining plasma reaction spaces between them. Gas, for example exhaust gas, subjected to plasma treatment is passed through the spaces from one side of the stack to the opposite side and undergoes reaction in a plasma generated by the electrodes. The electrodes have an electrically conductive film disposed inside a tabular ceramic material. In one construction shown, the gas being treated passes from one reaction space to the adjacent reaction space in the stack via holes in one electrode.

SUMMARY OF THE INVENTION

When processing gas using a catalyst, it is necessary to heat the processing target gas to 800 to 900°C in order to activate the catalyst. The catalyst quickly deteriorates when the processing target gas is heated to such a high temperature. This makes it necessary to use a large amount of expensive precious metal catalyst having high heat resistance.

Therefore, technology that more efficiently produces gas by utilizing a plasma reaction, a catalytic reaction, and the like has been desired. An object of the present invention is to provide a plasma reactor that can efficiently process gas by utilizing plasma, and a plasma reaction apparatus.

The inventors of the present invention found that the above object can be achieved by forming an integrated structure obtained by adjacently disposing a plasma reaction section that includes a pair of tabular electrodes formed of a ceramic dielectric and allows gas that passes through to undergo a reaction by generating plasma, and a heat-supplying gas circulation section that applies heat of a second gas that passes through to the plasma reaction section to promote the reaction of the gas. Specifically, the present invention provides the following plasma reactor and plasma reaction apparatus.

A plasma reactor comprising: a plasma reaction section that includes a pair of tabular electrodes facing each other arranged with an opening and generates plasma in a discharge section between the pair of tabular electrodes upon application of a voltage between the pair of tabular electrodes so that a first gas that passes through the discharge section is made to undergo a reaction, each of the pair of tabular electrodes including a ceramic dielectric and a conductor buried in the ceramic dielectric; and a heat-supplying gas circulation section that is stacked adjacently to the plasma reaction section and is integrally formed with the plasma reaction section, the heat-supplying gas circulation section applying heat of a second gas that passes through to the plasma reaction section to promote the reaction of the first gas.

The plasma reactor according to [1], wherein a catalyst is supported on a plasma generation surface of the tabular electrode.

The plasma reactor according to [1] or [2], wherein a catalyst is supported on a side of the heat-supplying gas circulation section that comes in contact with the gas that circulates in the heat-supplying gas circulation section.

The plasma reactor according to any one of [1] to [3], wherein the catalyst is a substance that contains at least one element selected from the group consisting of a precious metal, aluminum, nickel, zirconium, titanium, cerium, cobalt, manganese, zinc, copper, tin, iron, niobium, magnesium, lanthanum, samarium, bismuth, and barium.

The plasma reactor according to [4], wherein the precious metal is a substance that contains at least one element selected from the group consisting of platinum, rhodium, palladium, ruthenium, indium, silver, and gold.

The plasma reactor according to any one of [1] to [5], wherein a gas inlet and a gas outlet of the plasma reaction section and a gas inlet and a gas outlet of the heat-supplying gas circulation section are formed so that a first gas circulation direction and a second gas circulation direction are formed perpendicularly to a stacking direction of the plasma reaction section and the heat-supplying gas circulation section.

The plasma reactor according to [6], wherein a first gas circulation path and a second gas circulation path of the plasma reaction section are formed so that the first gas circulation direction in the plasma reaction section is perpendicular to the second gas circulation direction in the heat-supplying gas circulation section.

The plasma reactor according to [7], wherein the gas inlet and the gas outlet of the plasma reaction section are formed on one end face and the other end face of the plasma reactor in a direction perpendicular to the stacking direction.

The plasma reactor according to [7], wherein the gas inlet and the gas outlet of the plasma reaction section are formed on one end face of the plasma reactor in a direction perpendicular to the stacking direction.

The plasma reactor according to [6], wherein:
the gas inlet of the plasma reaction section and the gas outlet of the heat-supplying gas circulation section are formed on one end face of the plasma reactor in a direction perpendicular to the stacking direction; the gas outlet of the plasma reaction section and the gas inlet of the heat-supplying gas circulation section are formed on the other end face of the plasma reactor in the direction perpendicular to the stacking direction; and the gas inlet of the plasma reaction section and the gas inlet of the heat-supplying gas circulation section are formed at opposed positions, and the gas outlet of the plasma reaction section and the gas outlet of the heat-supplying gas circulation section are formed at opposed positions.

The plasma reactor according to any one of [1] to [10], wherein a plurality of the plasma reaction sections and a plurality of the heat-supplying gas circulation sections are alternately and integrally stacked.

The plasma reactor according to [6], wherein:
a gas introduction/circulation section is provided on a side of one of the pair of tabular electrodes opposite to an opening between the pair of tabular electrodes, the first gas being introduced into and circulating in the gas introduction/circulation section; a plurality of
through-holes are formed in the tabular electrode, the through-holes being formed from a side of the tabular electrode that faces the gas introduction/circulation section to a side of the tabular electrode that faces the opening; each of the through-holes is formed in an area of a conductor through-hole formed in the conductor and has a diameter smaller than that of the conductor through-hole; and the first gas is introduced into a space between the pair of tabular electrodes through the gas introduction/circulation section and the through-holes, and a voltage is applied between the pair of tabular electrodes to generate plasma in the discharge section between the pair of tabular electrodes.

The plasma reactor according to [12], wherein the heat-supplying gas circulation section that allows the second gas to circulate is integrally and adjacently stacked on a side of the gas introduction/circulation section opposite to the plasma reaction section.

The plasma reactor according to any one of [1] to [13], wherein the conductor buried in the ceramic dielectric extends to an end face of the tabular electrode and connected to a terminal, the terminal being integrally formed corresponding to a plurality of the tabular electrodes.

A plasma reaction apparatus comprising the plasma reactor according to any one of [1] to [14], and a pulse power supply that allows a pulse half-value width to be controlled to 1 microsecond or less.

Since the heat-supplying gas circulation section that allows the second gas to pass through is integrally and adjacently formed (stacked) with the plasma reaction section that allows the first gas to undergo a reaction due to plasma, the heat of the second gas can be applied to the plasma reaction section to promote the reaction of the first gas. Since the plasma reaction section and the heat-supplying gas circulation section are formed integrally, a reduction in size and an increase in heat transfer properties and heat retaining properties can be achieved. Since the plasma reactor has a stacked structure in which the heat exchanger and the reformer are integrated, the thermal efficiency can be improved. Since the tabular electrodes formed by the ceramic dielectric in which the conductor is buried are stacked, radicals can be produced by plasma generated by barrier discharge so that the reforming reaction temperature can be reduced by combining a catalytic reaction with a plasma reaction. Since the reactor has an integrated structure, the reactor can be easily connected to pipes. Moreover, the reactor is provided with reliable vibration resistance.

BRIEF DESCRIPTION OF THE DRAWINGS

FIG. 1 is a perspective view showing a plasma reactor according to a first embodiment of the present invention.
FIG. 2 is an exploded view showing the plasma reactor according to the first embodiment of the present invention.
FIG. 3 is a cross-sectional view showing the plasma reactor according to the first embodiment of the present invention.

FIG. 4 is a schematic view showing one embodiment of pipes connected to a plasma reactor.

FIG. 5 is a perspective view showing a plasma reactor according to a second embodiment of the present invention.

FIG. 6 is an exploded view showing the plasma reactor according to the second embodiment of the present invention.

FIG. 7 is a perspective view showing a plasma reactor according to a third embodiment of the present invention.

FIG. 8 is an exploded view showing the plasma reactor according to the third embodiment of the present invention.

FIG. 9 is a cross-sectional view showing the plasma reactor according to the third embodiment of the present invention.

FIG. 10 is an exploded view showing a plasma reactor according to a fourth embodiment of the present invention.

FIG. 11A is a cross-sectional view showing the plasma reactor according to the fourth embodiment of the present invention cut along a plane perpendicular to the gas circulation direction, and FIG. 11B is a cross-sectional view showing the plasma reactor according to the fourth embodiment of the present invention cut along a plane parallel to the gas circulation direction.

FIG. 12 is an enlarged cross-sectional view showing an area around a through-hole.

DESCRIPTION OF PREFERRED EMBODIMENTS

Embodiments of the present invention are described below with reference to the drawings. Note that the present invention is not limited to the following embodiments.

(First embodiment)

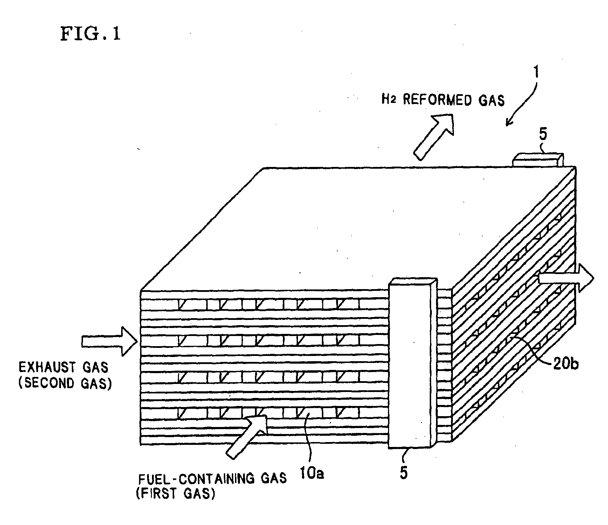

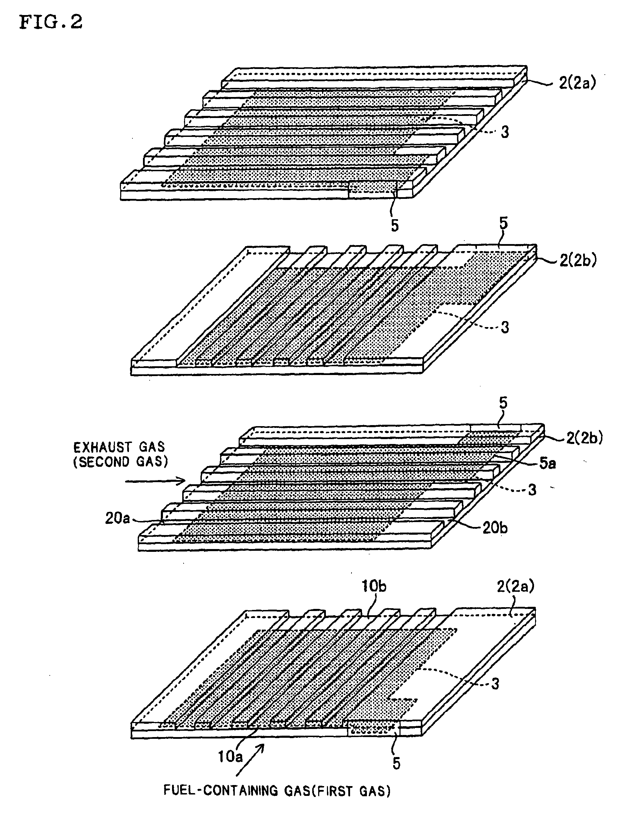

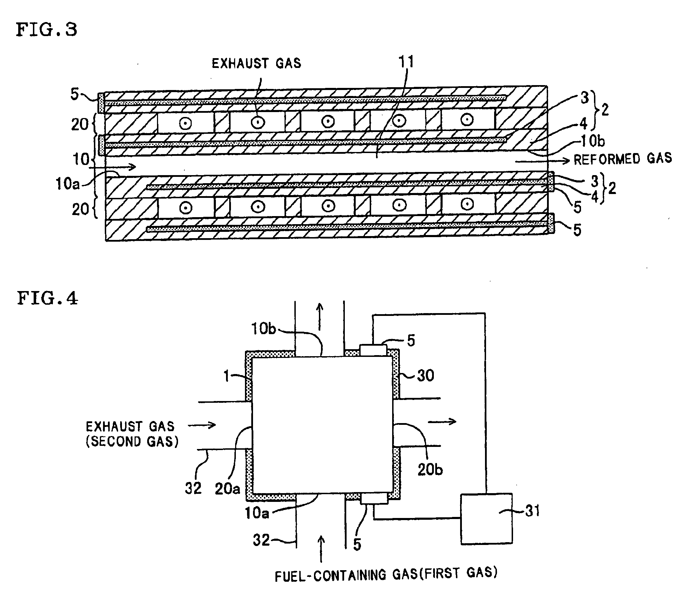

FIGS. 1 to 3 show a plasma reactor according to a first embodiment of the present invention. FIG. 1 is a perspective view, FIG. 2 is an exploded view, and FIG. 3 is a partially enlarged cross-sectional view.

A plasma reactor 1 includes a plasma reaction section 10 that includes a pair of tabular electrodes 2 facing each other arranged with an opening and generates plasma in a discharge section 11 between the pair of tabular electrodes 2 upon application of a voltage between the pair of tabular electrodes 2 so that a first gas that passes through the discharge section 11 is made to undergo a reaction, each of the pair of tabular electrodes 2 including a ceramic dielectric 4 and a conductor 3 buried in the ceramic dielectric 4, and a heat-supplying gas circulation section 20 that is stacked adjacently to the plasma reaction section 10 and is integrally formed with the plasma reaction section 10, the heat-supplying gas circulation section 20 applying heat of a second gas that passes through to the plasma reaction section 10 to promote the reaction of the first gas. The plasma reaction sections 10 and the heat-supplying gas circulation sections 20 are stacked alternately.

The plasma reaction section 10 and the heat-supplying gas circulation section 20 are formed by stacking the ceramic dielectrics 4 at an opening to form spaces that serve as a first gas circulation path and a second gas circulation path. It is preferable that a catalyst be supported on the side of a plasma generation surface of the tabular electrode 2 included in the plasma reaction section 10. A gas inlet 10a and a gas outlet 10b of the plasma reaction section 10 and a gas inlet 20a and a gas outlet 20b of the heat-supplying gas circulation section 20 are formed so that a first gas circulation direction and a second gas circulation direction are formed perpendicularly to the stacking direction of the plasma reaction section 10 and the heat-supplying gas circulation section 20. The first gas circulation path and the second gas circulation path of the plasma reaction section 10 are formed so that the first gas circulation direction in the plasma reaction section 10 is perpendicular to the second gas circulation direction in the heat-supplying gas circulation section 20. The gas inlet 10a and the gas outlet 10b of the plasma reaction section 10 are respectively formed on one end face and the other end face of the plasma reaction section 10 in the direction perpendicular to the stacking direction.

The plasma reactor 1 is formed of an integral sintered article of the ceramic tabular electrode 2 (basic electrode). The ceramic dielectric 4 that forms the tabular electrode 2 preferably contains a material having a high dielectric constant as the main component. For example, aluminum oxide, zirconium oxide, silicon oxide, mullite, cordierite, spinel, a titanium-barium type oxide, a magnesium-calcium-titanium type oxide, a barium-titanium-zinc type oxide, silicon nitride, aluminum nitride, or the like may be suitably used. It is preferable to appropriately select materials suitable for generating a plasma appropriate for a reaction of each component contained in a treatment target fluid and form the tabular electrode 2 using the materials. The plasma generating electrode can be operated at high temperature conditions using a material that exhibits excellent thermal impact resistance as the main component.

The tabular electrode 2 (basic electrode) before stacking refers to a sintered article obtained by sintering an integral firing target article such as a ceramic formed article, a ceramic degreased article, or a ceramic calcined article. A substrate production method is not particularly limited. A substrate may be produced by a green sheet lamination method, for example. Specifically, a substrate may be produced by press-forming a ceramic powder so that a metal sheet or metal foil that forms the electrode is buried in the ceramic powder, and sintering the resulting article.

A metal used for the buried electrode (conductor 3) is preferably a highly conductive metal. Examples of such a metal include a metal or an alloy containing at least one component selected from the group consisting of iron, gold, silver, copper, titanium, aluminum, nickel, chromium, tungsten, and molybdenum. The electrode may also be formed by applying a paste to a ceramic green sheet. In this case, an arbitrary coating method such as screen printing, colander roll printing, dipping, deposition, or physical vapor deposition may be used. When forming the electrode by the coating method, a powder of the above-mentioned metal or alloy is mixed with an organic binder and a solvent (e.g., terpineol) to prepare a conductive paste, and the conductive paste is applied to a ceramic green sheet.

When the substrate is produced, the forming method of the ceramic green sheet is not particularly limited. For example, a doctor blade method, a colander method, a printing method, a roll coating method, a plating method, or the like may be used. As the green sheet raw material powder, a powder of the above-mentioned ceramic, a glass powder, or the like may be used. In this case, silicon oxide, calcia, titania, magnesia, zirconia, or the like may be used as a sintering aid. The sintering aid is preferably added in an amount of 3 to 10 parts by weight based on 100 parts by weight of the ceramic powder. A dispersant, a plasticizer, and an organic solvent may be added to the ceramic slurry.

The substrate may also be produced by powder press forming. A sintered article in which an electrode is buried may be obtained by hot pressing by utilizing a mesh metal or metal foil as the electrode. A substrate formed article may be produced by extrusion forming by appropriately selecting a forming aid. An electrode may be formed on the surface of the extruded formed article by appropriately selecting a solvent and printing a metal paste (conductive film component).

The plasma reactor 1 according to the present invention is a heat exchanger-integrated stacked hybrid reactor. The heat exchanger-integrated stacked hybrid reactor refers to a structure in which a path for the first gas processed by plasma and a path for the second gas that applies heat to efficiently process the first gas are independently formed (stacked), and the gas inlet 10a and the gas outlet 10b for the first gas and the gas inlet 20a and the gas outlet 20b for the second gas are provided.

The conductor 3 buried in the ceramic dielectric 4 extends to the end face of the tabular electrode 2 and connected to a terminal 5. Since the plasma reaction sections 10 and the heat-supplying gas circulation sections 20 are stacked alternately, the terminal 5 is provided corresponding to a plurality of tabular electrodes 2. Therefore, a large amount of gas can be circulated and processed at the same time.

A first gas circulation path from the gas inlet 10a to the gas outlet 10b and a second gas circulation path from the gas inlet 20a to the gas outlet 20b are provided independently. As shown in FIG. 4, pipes 32 respectively connected to the gas inlet 10a and the gas outlet 10b for the first gas and the gas inlet 20a and the gas outlet 20b for the second gas are separated and shielded sufficiently so that the first gas and the second gas are not mixed. It is necessary that each pipe 32 is hollow so that the gas passes through. For example, each pipe 32 may be a cylindrical pipe, a rectangular pipe, or the like. The size of each pipe 32 may be appropriately determined depending on the application of the plasma reactor 1.

The materials for an outer housing 30, the pipe 32, and the like of the plasma reactor 1 are not particularly limited. It is preferable to form the outer housing 30 using a metal (e. g. , stainless steel) with excellent workability. It is preferable that the electrode installation section (e.g., near the terminal 5) inside the housing 30 be formed of an insulating material from the viewpoint of preventing a short circuit. As the insulating material, a ceramic may be suitably used. As the ceramic, alumina, zirconia, silicon nitride, aluminum nitride, sialon, mullite, silica, cordierite, or the like is preferably used. It is preferable to appropriately select the insulating material depending on the application of the plasma reactor 1. For example, cordierite or the like is used when insulating properties, thermal barrier properties, a reduction in thermal stress, or low heat capacity from the viewpoint of catalytic activity is important. Alumina or the like is used when strength is important at the sacrifice of insulating properties and thermal barrier properties. Silicon nitride or the like is used when heat transfer properties and the reliability of the structure are important. An insulating mat may be used instead of the insulating material. For example, a mullite fiber mat (trade name: "Maftec OBM" manufactured by Mitsubishi Chemical Functional Products Inc.) may be used.

It is preferable that a catalyst be supported on the plasma generation surface of the tabular electrode 2 that forms the plasma reaction section 10. It is also preferable that a catalyst be supported on the surface of the tabular electrode 2 that comes in contact with the gas that passes through the gas circulation path of the heat-supplying gas circulation section 20. The catalyst is not particularly limited insofar as the catalyst catalytically acts on the heat-supplying gas by a means other than an endothermic reaction. It is preferable to use a substance that acts on the heat-supplying gas by an exothermic reaction. For example, the catalyst may be a substance that contains at least one element selected from the group consisting of a precious metal (e.g., platinum, rhodium, palladium, ruthenium, indium, silver, and gold), aluminum, nickel, zirconium, titanium, cerium, cobalt, manganese, zinc, copper, tin, iron, niobium, magnesium, lanthanum, samarium, bismuth, and barium. A substance that contains the above-mentioned element may be a metal element, a metal oxide, other compounds (e.g., chloride and sulfate), or the like. These substances may be used either individually or in combination. It is preferable that the catalyst be supported on the wall of the reactor through which the gas passes in order to improve the reaction efficiency. Since the cells (gas passages) have a sufficient space, differing from a packed bed method in which the cells are filled with a particulate catalyst, passage of the gas is hindered to only a small extent. Since the catalyst component is supported on the wall of the reactor, heat is sufficiently transferred between the catalyst components. It is preferable that the catalyst be supported on the plasma generation surface of the tabular electrode 2 and the surface of the tabular electrode 2 that comes in contact with the gas that passes through the gas circulation path of the heat-supplying gas circulation section 20 in the form of catalyst-coated particles (i.e., the catalyst is supported on carrier particles). This improves the reaction efficiency of the reforming target gas with the catalyst. As the carrier particles, a ceramic powder or the like may be used. The type of ceramic is not particularly limited. For example, a powder of a metal oxide such as silica, alumina, titania, zirconia, ceria, zeolite, mordenite, silica-alumina, a metal silicate, or cordierite may be suitably used. These ceramic powders may be used either individually or in combination. The catalyst can be supported on the partition wall of the honeycomb electrode by coating the partition wall of the honeycomb electrode with the catalyst-coated particles.

The average particle diameter of the powder is preferably 0.01 to 50 $\mu$m, and more preferably 0.1 to 20 $\mu$m. If the average particle diameter of the powder is less than 0.01 $\mu$m, the catalyst may be supported on the surface of the carrier particles to only a small extent. If the average particle diameter of the powder exceeds 50 $\mu$m, the catalyst-coated particles may be easily removed from the honeycomb electrode.

The catalyst-coated particles may be obtained by impregnating the ceramic powder (carrier particles) with an aqueous solution containing the catalyst component, and drying and firing the resulting article. The catalyst can be supported on the honeycomb electrode by adding a dispersion medium (e.g., water) and additives to the catalyst-coated particles to prepare a coating liquid (slurry), and coating the honeycomb electrode with the slurry.

The mass ratio of the catalyst with respect to the carrier particle is preferably 0.1 to 20 mass%, and more preferably 1 to 10 mass%. If the mass ratio of the catalyst is less than 0.1 mass%, a reforming reaction may proceed to only a small extent. If the mass ratio of the catalyst exceeds 20 mass%, the catalyst components may aggregate without being uniformly dispersed so that the catalyst may not be uniformly supported on the carrier particles. Therefore, even if the catalyst is added in an amount of more than 20 mass%, a catalyst addition effect may not be achieved corresponding to the amount so that a reforming reaction may not be promoted.

The amount of catalyst supported on the honeycomb electrode is preferably 0.05 to 70 g/l, and more preferably 0.1 to 40 g/l. If the amount of catalyst supported on the honeycomb electrode is less than 0.05 g/l, the catalyst may not exhibit a catalytic effect. If the amount of catalyst supported on the honeycomb electrode exceeds 70 g/l, the production cost of the plasma reactor may increase.

Since the catalyst is supported on the plasma generation surface of the plasma reaction section 10, radicals can be produced by plasma generated by barrier discharge so that the first gas undergoes a reaction, and the reforming reaction temperature can be reduced by combining a catalytic reaction with a plasma reaction. Therefore, catalyst deterioration can be suppressed by reducing the reaction temperature, the amount of catalyst can be reduced by combining a catalytic reaction with a plasma reaction, and an inexpensive system can be implemented by reducing the amount of precious metal catalyst. As a result, the plasma reactor can be utilized in a wide range of applications.

A pulse power supply 31 is connected to the terminals 5 of the plasma reactor thus produced (see FIG. 4). A voltage is applied between the terminals 5 using the pulse power supply 31 to process the first gas by plasma. The pulse power supply 31 refers to a power supply that applies a pulse voltage to a pair of electrodes. A power supply that cyclically applies a voltage may be used as the pulse power supply. It is preferable to use a power supply that can supply (a) a pulse waveform having a peak voltage of 1 kV or more and a pulse number per second of 1 or more, (b) an AC voltage waveform having a peak voltage of 1 kV or more and a frequency of 1 or more, (c) a DC waveform having a voltage of 1 kV or more, or (d) a voltage waveform formed by superimposing these waveforms. The peak voltage of the power supply is preferably 1 to 20 kV, and more preferably 5 to 10 kV. The pulse width (half-value width) is preferably less than 1 microsecond. Examples of such a power supply include an inductive-energy-storage high-voltage pulse power supply (manufactured by NGK Insulators Ltd.) utilizing a static induction thyristor (SI thyristor) and the like. When processing the first gas, a reaction of the first gas can be promoted by heat of the second gas.

When producing hydrogen using the heat exchanger-integrated stacked hybrid reactor according to the present invention, the reforming target fuel is not particularly limited insofar as a hydrogen-containing gas can be produced. For example, a hydrocarbon compound (e.g., a light hydrocarbon such as methane, propane, butane, heptane, or hexane, a petroleum hydrocarbon such as isooctane, gasoline, kerosene, or naphtha) or an alcohol (e.g., methanol, ethanol, n-propanol, 2-propanol, and 1-butanol) may be used. A mixture of these compounds may also be used. A reforming method may be partial reforming that utilizes oxygen, steam reforming that utilizes water, autothermal reforming that utilizes oxygen and water, or the like.

The plasma reactor 1 according to the present invention is a small size and may be installed in an automobile or the like. Fuel (fuel-containing gas) is partially introduced as the first gas, and exhaust gas is introduced as the second gas. A reaction is promoted by utilizing heat of the exhaust gas to reform the fuel.

(Second embodiment)

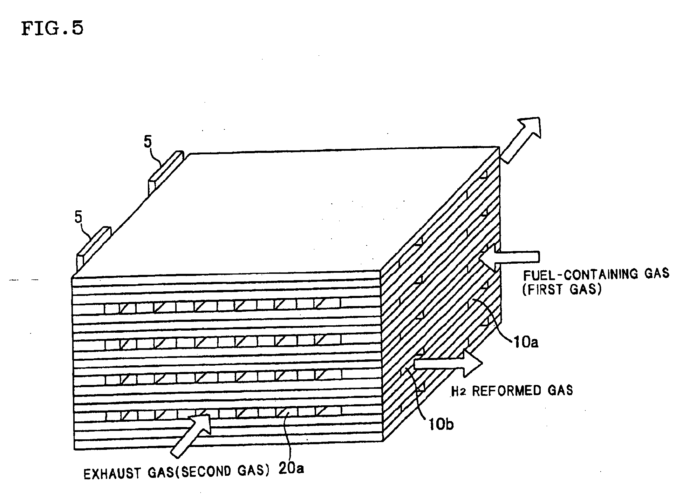

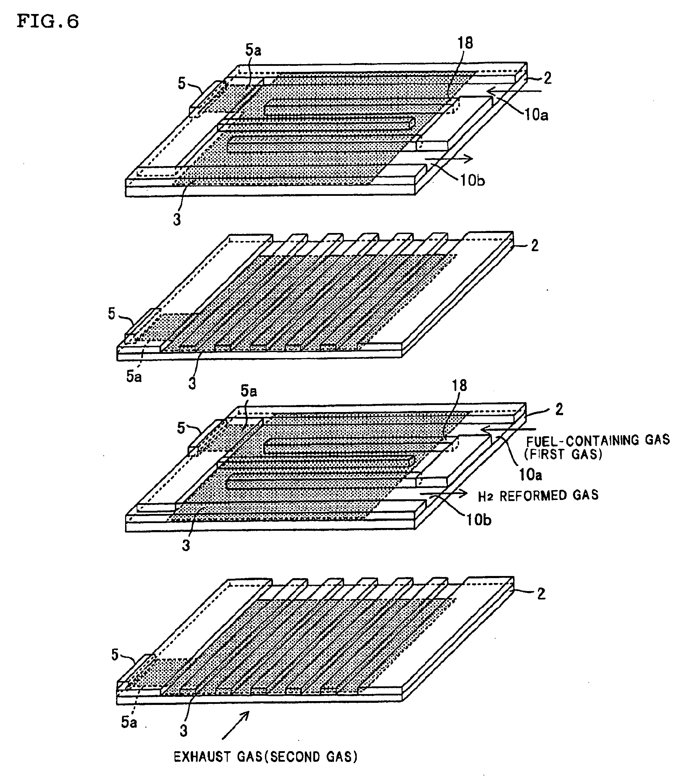

A plasma reactor 1 according to a second embodiment is described below with reference to FIGS. 5 and 6. The plasma reaction section 10 and the heat-supplying gas circulation section 20 are integrally stacked in the same manner as in the first embodiment. The first gas circulation direction and the second gas circulation direction are crossed to the stacking direction, and the first gas circulation path and the second gas circulation path are formed so that the first gas circulation direction is crossed to the second gas circulation direction.

In the second embodiment, the gas inlet 10a and the gas outlet 10b of the plasma reaction section 10 are formed on one end face of the plasma reaction section 10 in the direction crossed to the stacking direction. The terminals 5 connected to the pulse power supply 31 are formed on the end face opposite to the end face on which the gas inlet 10a and the gas outlet 10b of the plasma reaction section 10 are formed in order to apply a voltage between the tabular electrodes 2. Since the terminals 5 are formed on one end face at a distance at which the terminals 5 are insulated, the terminals can be provided on the different side through which the gas flows. Therefore, the terminals can be cooled sufficiently so that the terminals can be reliably provided with heat resistance. Since the terminals can be provided on the different side through which the gas flows, air-tightness can be easily maintained so that a compact reactor can be produced.

As shown in FIG. 6, the gas inlet 10a and the gas outlet 10b of the plasma reaction section 10 are formed on the same side of the end face of the plasma reaction section 10, and the first gas circulation path is formed to meander due to a restriction member 18 in a plane perpendicular to the stacking direction. Therefore, the first gas circulation path of the plasma reaction section 10 increases so that the first gas can be processed sufficiently. The second gas circulation path is formed so that the second gas linearly passes through second gas circulation path from one end face to the other end face in the same manner as in the first embodiment

(Third embodiment)

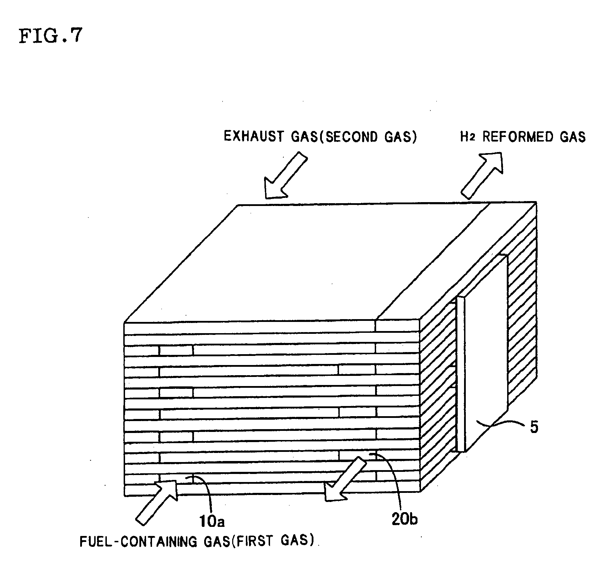

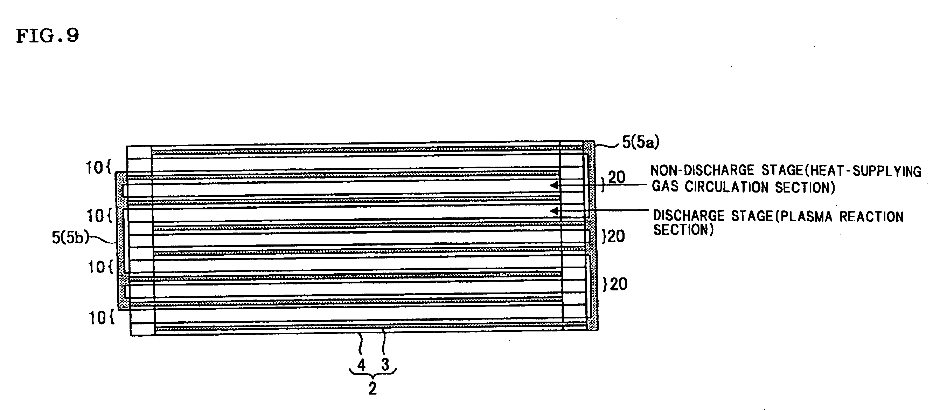

A plasma reactor 1 according to a third embodiment is described below with reference to FIGS. 7 to 9. The gas inlet 10a of the plasma reaction section 10 and the gas outlet 20b of the heat-supplying gas circulation section 20 are formed on one end face of the plasma reactor 1 in the direction cross to the stacking direction, and the gas outlet 10b of the plasma reaction section 10 and the gas inlet 20a of the heat-supplying gas circulation section 20 are formed on the other end face of the plasma reactor 1 in the direction cross to the stacking direction. The gas inlet 10a of the plasma reaction section 10 and the gas inlet 20a of the heat-supplying gas circulation section 20 are formed at opposed positions, and the gas outlet 10b of the plasma reaction section 10 and the gas outlet 20b of the heat-supplying gas circulation section 20 are formed at opposed positions. Specifically, the first gas and the second gas circulate along diagonal lines in each plane. The circulation paths are formed so that the first gas and the second gas circulate to intersect in different layers. The terminal 5 of a load electrode 5a and a ground electrode 5b are formed on opposite end faces.

(Fourth embodiment)

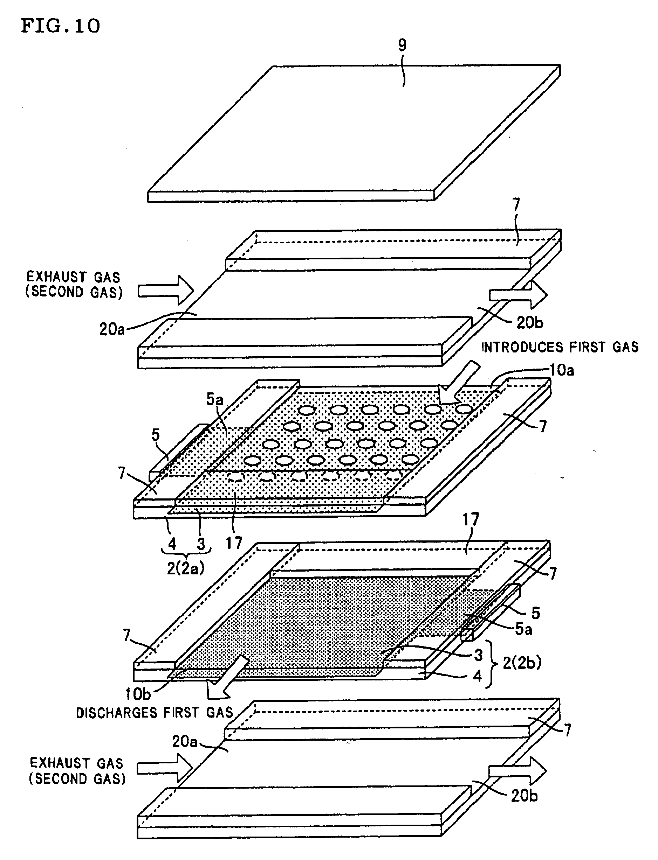

A plasma reactor 1 according to a fourth embodiment is described below with reference to FIGS. 10 to 12. In the plasma reactor 1 according to the fourth embodiment, a gas introduction/circulation section 21 is provided on the side of one of the pair of tabular electrodes 2 opposite to the opening between the pair of tabular electrodes 2, the first gas being introduced into and circulating in the gas introduction/circulation section 21, and a plurality of through-holes 15 are formed in the tabular electrode 2, the through-holes 15 being formed from the side of the tabular electrode 2 that faces the gas introduction/circulation section 21 to the side of the tabular electrode 2 that faces the opening. The heat-supplying gas circulation section 20 that allows the second gas to circulate is integrally and adjacently stacked on the side of the gas introduction/circulation section 21 opposite to the plasma reaction section 10. The first gas is introduced into the space between the tabular electrodes 2 through the gas introduction/circulation section 21 and the through-holes 15, and a voltage is applied between the tabular electrodes 2 to generate plasma in the discharge section 11 between the tabular electrodes 2.

Specifically, the plasma reactor 1 includes a first electrode 2a and a second electrode 2b (i.e., a plurality of tabular electrodes 2) that are stacked at a given interval, each of the first electrode 2a and the second electrode 2b including a plate-shaped ceramic dielectric 4 and a conductor 3 disposed in the ceramic dielectric 4. The interval between the first electrode 2a and the second electrode 2b is preferably 0.05 to 50 mm, and more preferably 0.1 to 10 mm. The first electrode 2a and the second electrode 2b (i.e., tabular electrodes 2) are held at an interval by support sections 7 to form a discharge section 11. It is preferable that the support sections 7 and the tabular electrode 2 be integrally formed and fired. A partition wall plate 9 is held by the support sections 7 at an interval from the side of the first electrode 2a opposite to the opening between the tabular electrodes 2a and 2b, and the gas introduction/circulation section 21 is formed by the support sections 7 and the partition wall plate 9. The support sections 7 and the partition wall plate 9 are stacked on the gas introduction/circulation section 21 to form the heat-supplying gas circulation section 20. The support sections 7 and the partition wall plate 9 are stacked adjacently to the second electrode 2b of the plasma reaction section 10 to form the heat-supplying gas circulation section 20. It is preferable that the partition wall plate 9, the first electrode 2a, the second electrode 2b, and a closing section 17 be integrally fired through the support sections 7 in order to prevent a breakage of the entire plasma reactor.

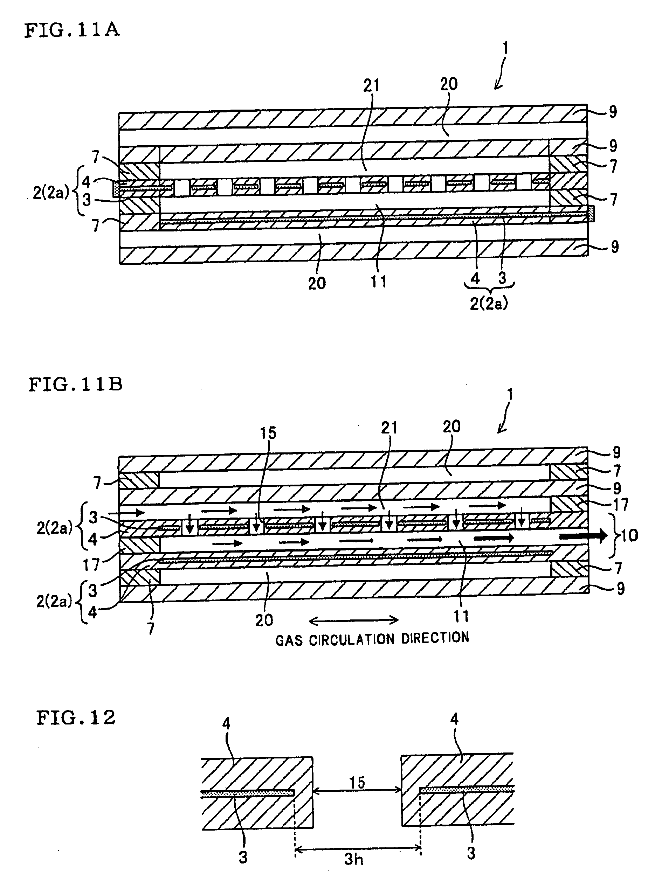

A plurality of through-holes 15 are formed in the first electrode 2a from the side of the first electrode 2a that faces the gas introduction/circulation section 21 to the side that faces the opening. The through-holes 15 are arranged in the tabular electrode 2 at least in the gas circulation direction. The through-holes 15 are formed in the ceramic dielectric 4 to have a diameter smaller than that of a conductor through-hole 3h formed in the conductor 3 disposed in the ceramic dielectric 4 (see enlarged cross-sectional view of area around the through-hole 15 shown in FIG. 12) so that dielectric breakdown of the conductor can be suppressed. The closing section 17 is formed on the end of the gas introduction/circulation section 21 opposite to the gas introduction side in the gas circulation direction. The end of the discharge section 11 on the side of the closing section 17 opposite to the gas introduction side of the gas introduction/circulation section 21 is an opening so that the gas can be exhausted. Specifically, the gas is introduced into the space between the tabular electrodes 2a and 2b through the gas introduction/circulation section 21 and the through-holes 15, and a voltage is applied between the tabular electrodes 2a and 2b to generate plasma in the discharge section 11 between the tabular electrodes 2a and 2b.

The positions, the number, and the size of the through-holes 15 (hereinafter may be referred to as "electrode through-holes" in order to clearly distinguish the through-holes 15 from the conductor through-holes 3h formed in the conductor 3) may be arbitrarily determined. It is preferable to regularly dispose the through-holes 15 at equal intervals. The ratio of the total area of the electrode through-holes 15 to the outer circumferential area of the conductor 3 is preferably 1 to 50%, and more preferably 2 to 30%. If the ratio is less than 1%, the amount of gas supplied may decrease due to an increase in gas back pressure. As a result, a sufficient reaction may not occur. If the ratio is more than 50%, the reaction efficiency may decrease due to a decrease in discharge area. The ratio of the effective discharge area other than the conductor through-holes 3h to the outer circumferential area of the conductor 3 is preferably 30 to 98%, and more preferably 50 to 90%. If the ratio is less than 30%, the reaction efficiency may decrease due to a decrease in the total area of the discharge section 11. If the ratio is more than 98%, it may be difficult to suppress dielectric breakdown when the ratio of the total area of the electrode through-holes 15 to the outer circumferential area of the conductor 3 is 1 % or more.

It is preferable to concentrically dispose the electrode through-hole 15 and the conductor through-hole 3h. Note that the electrode through-hole 15 and the conductor through-hole 3h need not be concentrically disposed insofar as a sufficient insulation distance is provided. The diameter of the electrode through-hole must be smaller than the diameter of the conductor through-hole. The difference between the diameter of the electrode through-hole and the diameter of the conductor through-hole is preferably 0.5 mm or more, and more preferably 1 mm or more. If the difference between the diameter of the electrode through-hole and the diameter of the conductor through-hole is 0.5 mm or less, a dielectric breakdown may occur. The diameter of the electrode through-hole is preferably 0.1 to 10 mm, and more preferably 1 to 5 mm. If the diameter of the electrode through-hole is less than 0.1 mm, a sufficient amount of gas may not be supplied. If the diameter of the electrode through-hole is more than 10 mm, the reaction efficiency may not be increased due to a decrease in discharge area.

The thickness of the conductor 3 that forms the tabular electrode 2 is preferably 0.001 to 0.1 mm, and more preferably 0.005 to 0.05 mm from the viewpoint of the adhesion between the conductor 3 and the substrate.

According to the above configuration, the first gas can be introduced through the gas introduction/circulation section 21 and reacted in the discharge section 11. Since the through-holes 15 are arranged in the gas circulation direction, unreacted gas can be introduced into the discharge section 11 in a dispersed state. Therefore, the gas can be efficiently processed.

EXAMPLES

The present invention is further described below based on examples. Note that the present invention is not limited to the following examples.

(Example 1)

>

(1) Production of alumina tabular electrode (basic electrode)

A forming aid, a plasticizer, and the like were added to a 93% alumina ($Al_2O_3$) raw material to prepare an alumina tape (thickness after firing: 0.25 mm). An alumina tabular plate (basic electrode) having a width of 50 mm and a length of 60 mm was prepared using the resulting tape. A conductor film (conductor 3) having a width of 48 mm, a length of 45 mm, and a thickness of 10 $\mu$m was printed on the alumina tabular plate using a tungsten paste to obtain an integrally stacked tabular electrode. A pull-out section 5a connected to the terminal 5 was also printed (see FIG. 2). The same tape material as the alumina tape on which the conductor film was printed was then press-bonded with heating to obtain an alumina tabular electrode (tabular electrode 2) having a thickness of 0.5 mm.

(2) Production of cross-flow heat exchanger-integrated through-flow reactor (first embodiment)

A support section 7 was formed by stacking four alumina tapes having a thickness of 0.25 mm so that a discharge space having a thickness of 1 mm was provided. As shown in FIGS. 1 to 3, the support section 7 was provided on the alumina tabular electrode to provide two gas circulation paths. The resulting article was press-bonded with heating to obtain an alumina formed article in which a cross-flow heat exchanger and a through-flow reactor were integrated and which had a plasma reaction section 10 and a high-temperature gas circulation section (heat-supplying gas circulation section 20). The formed article was fired at 1500°C to obtain an integrated reactor similar to that of the first embodiment (FIGS. 1 to 3).

(Example 2)

Production of cross-flow heat exchanger-integrated catalyst-supporting through-flow reactor (first embodiment) An alumina fine powder (specific surface area: 107 m$^2$/g) was impregnated with a nickel nitrate ($Ni(NO_3)_2$) aqueous solution, dried at 120°C, and fired at 550°C for three hours in air to obtain an Ni/alumina powder containing nickel (Ni) in an amount of 20 mass% based on alumina. After the addition of alumina sol and water to the Ni/alumina powder, the pH of the mixture was adjusted to 4.0 using a nitric acid solution to obtain a slurry. The reactor was immersed in the slurry, dried at 120°C, and fired at 550°C for one hour in a nitrogen atmosphere to obtain a cross-flow heat exchanger-integrated catalyst-supporting through-flow reactor shown in FIGS. 1 to 3. The amount of Ni supported on the reactor was 30 g/l.

(Example 3)

>

(1) Production of cordierite tabular electrode (basic electrode)

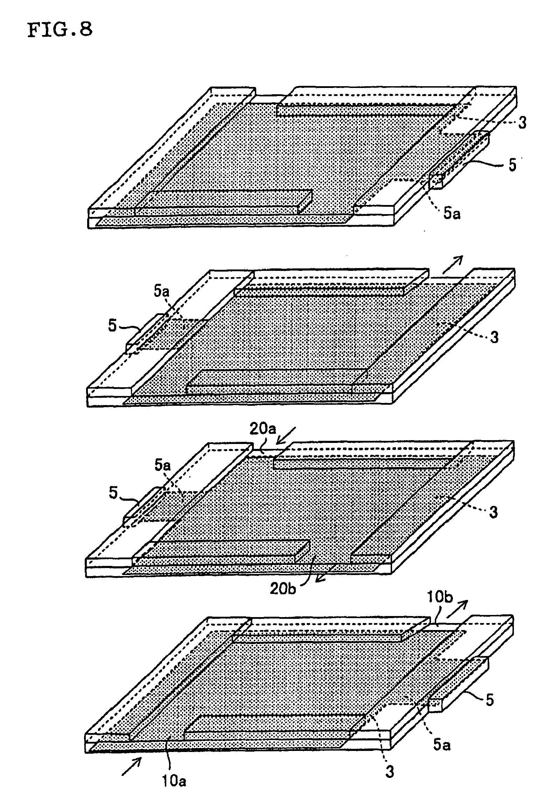

A cordierite tape (thickness after firing: 0.25 mm) was prepared using cordierite of which the average particle diameter was adjusted to 2 $\mu$m. A cordierite tabular plate (basic electrode) having a width of 50 mm and a length of 60 mm was prepared using the resulting tape. A conductor film having a width of 48 mm, a length of 45 mm, and a thickness of 10 $\mu$m was printed on the cordierite tabular plate using a molybdenum paste to obtain an integrally stacked tabular electrode. A pull-out section connected to the terminal 5 shown in FIG. 8 was also printed. The same tape material as the cordierite tape on which the conductor film was printed was then press-bonded with heating to obtain a cordierite tabular electrode having a thickness of 0.5 mm.

(2) Production of counter-flow heat exchanger-integrated through-flow reactor (third embodiment)

A support section 7 was formed by stacking four cordierite tapes having a thickness of 0.25 mm so that a discharge space having a thickness of 1 mm was provided. As shown in FIGS. 7 to 9, the support section 7 was provided on the cordierite tabular electrode to provide two gas circulation paths. The resulting article was press-bonded with heating to obtain a cordierite formed article in which a counter-flow heat exchanger and a through-flow reactor were integrated and which had a plasma reaction section and a high-temperature gas circulation section (heat-supplying gas circulation section 20). The formed article was fired at 1400°C to obtain an integrated reactor similar to that of the third embodiment (FIGS. 7 to 9).

(Example 4)

>

(1) Production of counter-flow heat exchanger-integrated catalyst-supporting through-flow reactor (third embodiment)

Alumina fine powder (specific surface area: 107 m²/g) was impregnated with a nickel nitrate ($Ni(NO_3)_2$) solution, dried at 120°C, and fired at 550°C for three hours in air to obtain Ni/alumina powder containing nickel (Ni) in an amount of 20 mass% based on alumina. After the addition of alumina sol and water to the Ni/alumina powder, the pH of the mixture was adjusted to 4.0 using a nitric acid solution to obtain a slurry.
The reactor was immersed in the slurry, dried at 120°C, and fired at 550°C for one hour in a nitrogen atmosphere to obtain a counter-flow heat exchanger-integrated catalyst-supporting through-flow reactor similar to that of the third embodiment (FIGS. 7 to 9). The amount of Ni supported on the reactor was 30 g/l.

(Example 5)

>

(1) Production of silicon nitride tabular electrode (basic electrode)

5 mass% of MgO and 5 mass% of $Y_2O_3$ were added to silicon nitride ($Si_3N_4$) raw material (specific surface area: 2 to 5 m²/g) to prepare a silicon nitride tape (thickness after firing: 0.25 mm). A silicon nitride tabular plate (basic electrode) having a width of 50 mm and a length of 60 mm was prepared using the resulting tape. A conductor film having a width of 48 mm, a length of 45 mm, and a thickness of 10 μm was printed on the silicon nitride tabular plate using a molybdenum paste to obtain an integrally stacked tabular electrode. A pull-out section connected to the terminal 5 shown in FIG. 10 was also printed. The same tape material as the silicon nitride tape on which the conductor film was printed was then press-bonded with heating to obtain a silicon nitride tabular electrode having a thickness of 0.5 mm.

(2) Production of cross-flow heat exchanger-integrated wall-flow reactor (fourth embodiment)

A support section was formed by stacking four silicon nitride tapes having a thickness of 0.25 mm so that a discharge space having a thickness of 1 mm was provided. As shown in the drawing, the support section was provided on the silicon nitride tabular electrode to provide two gas circulation paths. The resulting article was press-bonded with heating to obtain a silicon nitride formed article in which a cross-flow heat exchanger and a through-flow reactor were integrated and which had a plasma reaction section and a high-temperature gas circulation section. The formed article was fired at 1800°C to obtain an integrated reactor similar to that of the fourth embodiment (FIGS. 10 to 12).

(Example 6)

Production of cross-flow heat exchanger-integrated catalyst-supporting wall-flow reactor (fourth embodiment)

Alumina fine powder (specific surface area: 107 m²/g) was impregnated with a nickel nitrate ($Ni(NO_3)_2$) solution, dried at 120°C, and fired at 550°C for three hours in air to obtain Ni/alumina powder containing nickel (Ni) in an amount of 20 mass% based on alumina. After the addition of alumina sol and water to the Ni/alumina powder, the pH of the mixture was adjusted to 4.0 using a nitric acid solution to obtain a slurry.
The reactor was immersed in the slurry, dried at 120°C, and fired at 550°C for one hour in a nitrogen atmosphere to obtain a cross-flow heat exchanger-integrated catalyst-supporting wall-flow reactor similar to that of the fourth embodiment (FIGS. 10 to 12). The amount of Ni supported on the reactor was 30 g/l.

(Example 7)

Production of cross-flow heat exchanger-integrated through-flow reactor (first embodiment)

A reactor having the same size and the same structure as those of Example 1 was produced, except for using cordierite as the insulating material instead of alumina. Specifically, a support section 7 was formed by stacking four cordierite tapes having a thickness of 0.25 mm so that a discharge space having a thickness of 1 mm was provided. As shown in FIGS. 1 to 3, the support section 7 was provided on the cordierite tabular electrode to provide two gas circulation paths. The resulting article was press-bonded with heating to obtain a cordierite formed article in which a cross-flow heat exchanger and a through-flow reactor were integrated and which had a plasma reaction section 10 and a high-temperature gas circulation section (heat-supplying gas circulation section 20). The formed article was fired at 1400°C to obtain an integrated reactor similar to that of the first embodiment (FIGS. 1 to 3).

(Hydrocarbon reforming test)

A hydrocarbon reforming test was conducted using the heat exchanger-integrated stacked hybrid reactors of Examples 1 to 4 and 7 and the heat exchanger-integrated catalyst-supporting stacked hybrid reactors of Examples 5 and 6. Isooctane (i-$C_8H_{18}$) was used as the hydrocarbon. i-$C_8H_{18}$ was reformed by partial oxidation. Since i-$C_8H_{18}$ is liquid, a gas introduced into the reactor was heated to 290°C in advance, and a specific amount of i-$C_8H_{18}$ was injected using a high-pressure microfeeder ("JP-H" manufactured by Furue Science K.K.) to vaporize i-$C_8H_{18}$. A fuel-containing model gas contained 2000 ppm of i-$C_8H_{18}$ and 8000 ppm of $O_2$ with the balance being $N_2$ gas. The fuel model gas was introduced into the fuel-containing gas pipe of the reactor. The space velocity (SV) of the fuel-containing model gas was 100,000 h$^{-1}$ with respect to the plasma generation space of the reactor. Air was used as exhaust model gas. The model gas was heated to 600°C in advance, and introduced into the exhaust gas pipe of the reactor. The space velocity (SV) of air was 100, 000 h$^{-1}$ with respect to the exhaust gas passage space of the reactor.

The fuel-containing model gas was introduced into each reactor, the amount of $H_2$ contained in the gas exhausted from the plasma reactor was measured by a gas chromatography (GC) apparatus ("GC3200" manufactured by GL Sciences Inc., carrier gas: argon gas) equipped with a thermal conductivity detector (TCD), and the $H_2$ yield was calculated. The amount of ethane ($C_2H_6$) contained in the exhausted model gas was measured using helium gas as the GC carrier gas. $C_2H_6$ is a by-product. A mixed reference gas ($H_2$ and $C_2H_6$) having a known concentration was used and measured in advance. The pulse power supply for generating plasma was set at a repetition cycle of 3 kHz. A peak voltage of 4.5 kV was applied between the electrodes. A hydrogen production experiment was conducted under the same conditions using a reactor on which a catalyst was not supported. The $H_2$ yield was calculated using the following expression (1).

$$H_2 \text{ yield (\%)} = H_2 \text{ production amount (ppm)} / \text{i-}C_8H_{18}$$

$$\text{amount (ppm) in model gas} \times 9 \quad (1)$$

(Comparative Examples 1 to 3)

Comparison of presence or absence of heat exchanger function

Stacked reactors similar to those of Examples 1 to 3 that did not have an exhaust gas passage (heat-supplying gas circulation section 20) and had only a fuel-containing gas passage and a reformed gas passage (plasma reaction section 10) were produced. An i-$C_8H_{18}$ reforming test was conducted under the same conditions as in the examples. The reactor of Comparative Example 1 (electrode material and insulating material: alumina) corresponds to Example 1 (electrode material and insulating material: alumina), the reactor of Comparative Example 2 (electrode material and insulating material: cordierite) corresponds to Example 3 (electrode material and insulating material: cordierite), and the reactor of Comparative Example 3 (electrode material and insulating material: silicon nitride) corresponds to Example 5 (electrode material and insulating material: silicon nitride). The volume of the plasma generating space of the reactors of Comparative Examples 1 to 3 was the same as those of Examples 1, 3, and 5. The reactor was placed in an electric furnace instead of introducing exhaust gas into the reactor. The heating temperature of the electric furnace was set so that the temperature of the reformed gas exhausted from the reactor was the same as those of the examples.

(Comparative Examples 4 to 6)

Comparison of presence or absence of catalyst

A 20 mass% Ni/$Al_2O_3$ catalyst was supported on the stacked reactors of Comparative Examples 1 to 3 in the same manner as in the examples. The amount of Ni supported on the reactor was 30 g/l. An i-$C_8H_{18}$ reforming test was conducted under the same conditions as in Comparative Examples 1 to 3 using the resulting reactors.

(Comparative Example 7)

Comparison of material for plasma reactor

A plasma reactor (Comparative Example 7) having the same size and the same structure as those of Comparative Example 1 was produced using cordierite as the material in order to examine the difference in performance due to the difference in electrode material and insulating material. An i-$C_8H_{18}$ reforming test was conducted under the same conditions as in the examples.

(Comparative Example 8)

Comparison of integrated structure of plasma reactor

A plasma reactor (Comparative Example 8) having the same size, structure, and materials as those of Example 1 was produced. The plasma reactor of Comparative Example 8 had an exhaust gas passage (heat-supplying gas circulation section 20), but was produced by stacking and fixing tabular electrodes (basic electrodes) instead of forming an integral structure by firing. Iso-$C_8H_{18}$ reforming test was conducted under the same conditions as in the examples.

(Results)

Table 1 shows the measurement results for reformed gas produced in Examples 1 to 7, and Table 2 shows the measurement results for reformed gas produced in Comparative Examples 1 to 8. The $C_2H_6$ concentration ratio shown in Tables 1 and 2 is given by taking the $C_2H_6$ concentration of Example 1 as 1 (reference value).

TABLE 1

| | Example | | | | | | |
|---|---|---|---|---|---|---|---|
| | 1 | 2 | 3 | 4 | 5 | 6 | 7 |
| $H_2$ (%) | 31 | 43 | 28 | 39 | 26 | 32 | 37 |
| $C_2H_6$ concentration ratio | 1 | 0.4 | 1.1 | 0.7 | 1.4 | 0.9 | 0.8 |

TABLE 2

| | Comparative Example | | | | | | | |
|---|---|---|---|---|---|---|---|---|
| | 1 | 2 | 3 | 4 | 5 | 6 | 7 | 8 |
| $H_2$ (%) | 15 | 14 | 11 | 21 | 19 | 16 | 18 | 21 |
| $C_2H_6$ concentration ratio | 2.1 | 2.4 | 3.0 | 1.6 | 1.7 | 1.9 | 1.7 | 1.6 |

The hydrogen production rates achieved in Examples 2, 4, and 6 in which plasma discharge was combined with a catalyst were higher than the hydrogen production rates achieved in Examples 1, 3, and 5 in which only plasma discharge was used. The amount of by-products such as $C_2H_6$ produced in Examples 2, 4, and 6 was small as compared with of Examples 1, 3, and 5. When comparing Comparative Examples 1 to 3 with Comparative Examples 4 to 6, the hydrogen production rate increased and the amount of by-products such as $C_2H_6$ decreased by combining plasma discharge with a catalyst. Therefore, it was confirmed that hydrogen can be efficiently produced from i-$C_8H_{18}$ by reforming i-$C_8H_{18}$ by means of plasma discharge and a catalyst.

When comparing Examples 1, 3, and 5 with Comparative Examples 1 to 3, a high hydrogen production rate was achieved and production of by-products such as $C_2H_6$ was suppressed in Examples 1, 3, and 5 as compared with Comparative Examples 1 to 3. This suggests that the heat exchanger-integrated reactor that allows exhaust gas to pass through the reactor allows the heat of the exhaust gas to efficiently contribute to a reaction so that a high hydrogen production rate is achieved as compared with the comparative examples which are heated from outside.

The hydrogen production rate achieved in Example 7 was higher than that of Example 1 under the same conditions. Therefore, it was confirmed that it is desirable to use cordierite having thermal barrier properties higher than those of alumina as the insulating material for the plasma reactor. The hydrogen production rate achieved in Comparative Example 7 was higher to some extent than that of Comparative Example 1, but was lower than that of Example 1. Therefore, it was confirmed that the plasma reactor according to the present invention achieves a higher hydrogen production rate.

When comparing Example 1 with Comparative Example 8, the hydrogen production rate achieved in Comparative Example 8 was lower that that of Example 1 under the same conditions, and the $C_2H_6$ concentration ratio achieved in Comparative Example 8 was higher that that of Example 1, although the plasma reactors of Example 1 and Comparative Example 8 had a heat exchanger function. This indicates that the reactor exhibits low thermal efficiency and low reaction efficiency when merely stacking the tabular electrodes (basic electrodes). Specifically, the thermal efficiency of the reactor can be increased by forming an integral structure as in the present invention so that the hydrogen production rate can be increased.

The plasma reactor according to the present invention can be suitably used for a reforming reaction of a hydrocarbon compound or an alcohol, and can be particularly suitably used for a hydrogen production reaction. Since the plasma reactor according to the present invention can stably supply a large amount of reformed gas for a long period of time, the plasma reactor according to the present invention can also be suitably used for applications such as an on-vehicle fuel reformer that utilizes automotive exhaust gas to apply heat.

**Claims**

1.  A plasma reactor comprising:

    a plasma reaction section (10) that includes a pair of tabular electrodes (2) facing each other arranged with an opening and generates plasma in a discharge section (11) between the pair of tabular electrodes (2) upon application of a voltage between the pair of tabular electrodes so that a first gas that passes through the discharge section (11) is made to undergo a reaction, each of the pair of tabular electrodes (2) including a ceramic dielectric (4) and a conductor (3) buried in the ceramic dielectric;
    **characterized by**:

    a heat-supplying gas circulation section (20) that is stacked adjacent to the plasma reaction section (10) and is integrally formed with the plasma reaction section, the heat-supplying gas circulation section (20) applying heat of a second gas, said heat passing through to the plasma reaction section (10) to promote the reaction of the first gas.

2.  The plasma reactor according to claim 1, wherein a catalyst is supported on a plasma generation surface of the tabular electrode (2).

3.  The plasma reactor according to claim 1 or 2, wherein a catalyst is supported on a side of the heat-supplying gas circulation section (20) that comes in contact with the gas that circulates in the heat-supplying gas circulation section (20).

4.  The plasma reactor according to any one of claims 1 to 3, wherein the catalyst is a substance that contains at least one element selected from the group consisting of a precious metal, aluminum, nickel, zirconium, titanium, cerium, cobalt, manganese, zinc, copper, tin, iron, niobium, magnesium, lanthanum, samarium, bismuth, and barium.

5.  The plasma reactor according to claim 4, wherein the precious metal is a substance that contains at least one element selected from the group consisting of platinum, rhodium, palladium, ruthenium, indium, silver, and gold.

6.  The plasma reactor according to any one of claims 1 to 5, wherein a gas inlet (10a) and a gas outlet (10b) of the plasma reaction section (10) and a gas inlet (20a) and a gas outlet (20b) of the heat-supplying gas circulation section (20) are formed so that a first gas circulation direction and a second gas circulation direction are formed perpendicularly to a stacking direction of the plasma reaction section and the heat-supplying gas circulation section.

7.  The plasma reactor according to claim 6, wherein a first gas circulation path and a second gas circulation path of the plasma reaction section (10) are formed so that the first gas circulation direction in the plasma reaction section is perpendicular to the second gas circulation direction in the heat-supplying gas circulation section (20).

8.  The plasma reactor according to claim 7, wherein the gas inlet (10a) and the gas outlet (10b) of the plasma reaction section are formed on one end face and the other end face of the plasma reactor in a direction perpendicular to the stacking direction.

9.  The plasma reactor according to claim 7, wherein the gas inlet (10a) and the gas outlet (10b) of the plasma reaction section are formed on one end face of the plasma reactor in a direction perpendicular to the stacking direction.

10. The plasma reactor according to claim 6, wherein:

the gas inlet (10a) of the plasma reaction section (10) and the gas outlet (20b) of the heat-supplying gas circulation section (20) are formed on one end face of the plasma reactor in a direction perpendicular to the stacking direction;

the gas outlet (10b) of the plasma reaction section (10) and the gas inlet (20a) of the heat-supplying gas circulation section (20) are formed on the other end face of the plasma reactor in the direction perpendicular to the stacking direction; and

the gas inlet (10a) of the plasma reaction section and the gas inlet (20a) of the heat-supplying gas circulation section are formed at opposed positions, and the gas outlet (10b) of the plasma reaction section and the gas outlet (20b) of the heat-supplying gas circulation section are formed at opposed positions.

11. The plasma reactor according to any one of claims 1 to 10, wherein a plurality of the plasma reaction sections (10) and a plurality of the heat-supplying gas circulation sections (20) are alternately and integrally stacked.

12. The plasma reactor according to claim 6, wherein:

a gas introduction/circulation section (21) is provided on a side of one of the pair of tabular electrodes (2) opposite to an opening between the pair of tabular electrodes, the first gas being introduced into and circulating in the gas introduction/circulation section (21);

a plurality of through-holes (15) are formed in the tabular electrode (2), the through-holes (15) being formed from a side of the tabular electrode (2) that faces the gas introduction/circulation section (21) to a side of the tabular electrode that faces the opening;

each of the through-holes is formed in an area of a conductor through-hole (3h) formed in the conductor (3) and has a diameter smaller than that of the conductor through-hole (3h); and

the first gas is introduced into a space between the pair of tabular electrodes through the gas introduction/circulation section (21) and the through-holes (15), and a voltage is applied between the pair of tabular electrodes (2) to generate plasma in the discharge section between the pair of tabular electrodes.

13. The plasma reactor according to claim 12, wherein the heat-supplying gas circulation section (20) that allows the second gas to circulate is integrally and adjacently stacked on a side of the gas introduction/circulation section (21) opposite to the plasma reaction section (10).

14. The plasma reactor according to any one of claims 1 to 13, wherein the conductor (3) buried in the ceramic dielectric extends to an end face of the tabular electrode and is connected to a terminal (5), the terminal being integrally formed corresponding to a plurality of the tabular electrodes (2).

15. A plasma reaction apparatus comprising the plasma reactor according to any one of claims 1 to 14, and a pulse power supply (31) that allows a pulse half-value width to be controlled to 1 microsecond or less.

**Patentansprüche**

1. Plasmareaktor, der Folgendes umfasst:

einen Plasmareaktionsabschnitt (10), der ein Paar Flachelektroden (2) umfasst, die einander zugewandt mit einer Öffnung dazwischen angeordnet sind, und bei Anlegen einer Spannung zwischen dem Flachelektrodenpaar Plasma in einem Entladungsabschnitt (11) zwischen dem Flachelektrodenpaar (2) erzeugt, so dass ein erstes Gas, das sich durch den Entladungsabschnitt (11) hindurch bewegt, einer Reaktion unterzogen wird, wobei jedes der Elektronenblättchen (2) des Paars ein Keramikdielektrikum (4) und einen in dem Keramikdielektrikum eingebetteten Leiter (3) umfasst;
**gekennzeichnet durch**:

einen Wärmezufuhrgaszirkulationsabschnitt (20), der an den Plasmareaktionsabschnitt (10) angrenzend auf diesen aufgestapelt und einstückig mit dem Plasmareaktionsabschnitt ausgebildet ist, wobei der Wärmezufuhrgaszirkulationsabschnitt (20) die Wärme eines zweiten Gases abgibt, wobei die Wärme **durch** den Plasmareaktionsabschnitt (10) geleitet wird, um die Reaktion des ersten Gases zu unterstützen.

2. Plasmareaktor nach Anspruch 1, worin ein Katalysator auf einer Plasmaerzeugungsoberfläche der Flachelektrode (2) aufgebracht ist.

3. Plasmareaktor nach Anspruch 1 oder 2, worin ein Katalysator auf einer Seite des Wärmezufuhrgaszirkulationsabschnitts (20), die mit dem Gas, das in dem Wärmezufuhrgaszirkulationsabschnitts (20) zirkuliert, in Berührung kommt, aufgebracht ist.

4. Plasmareaktor nach einem der Ansprüche 1 bis 3, worin der Katalysator eine Substanz ist, die zumindest ein aus der aus folgenden bestehenden Gruppe ausgewähltes Element enthält: Edelmetall, Aluminium, Nickel, Zirkonium, Titan, Cerium, Kobalt, Mangan, Zink, Kupfer, Zinn, Eisen, Niobium, Magnesium, Lanthan, Samarium, Wismut und Barium.

5. Plasmareaktor nach Anspruch 4, worin das Edelmetall eine Substanz ist, die zumindest ein aus der aus folgenden bestehenden Gruppe ausgewähltes Element enthält: Platin, Rhodium, Palladium, Ruthenium, Indium, Silber und Gold.

6. Plasmareaktor nach einem der Ansprüche 1 bis 5, worin ein Gaseinlass (10a) und ein Gasauslass (10b) des Plasmareaktionsabschnitts (10) und ein Gaseinlass (20a) und ein Gasauslass (20b) des Wärmezufuhrgaszirkulationsabschnitts (20) so ausgebildet sind, dass eine erste Gaszirkulationsrichtung und eine zweite Gaszirkulationsrichtung im rechten Winkel auf die Stapelrichtung des Plasmareaktionsabschnitts und des Wärmezufuhrgaszirkulationsabschnitts ausgebildet sind.

7. Plasmareaktor nach Anspruch 6, worin ein erster Gaszirkulationsweg und ein zweiter Gaszirkulationsweg des Plasmareaktionsabschnitts (10) so ausgebildet sind, dass die erste Gaszirkulationsrichtung in dem Plasmareaktionsabschnitt im rechten Winkel auf die zweite Gaszirkulationsrichtung in dem Wärmezufuhrgaszirkulationsabschnitt (20) steht.

8. Plasmareaktor nach Anspruch 7, worin der Gaseinlass (10a) und der Gasauslass (10b) des Plasmareaktionsabschnitts in einer Richtung im rechten Winkel auf die Stapelrichtung an einer Endfläche und der anderen Endfläche des Plasmareaktors ausgebildet sind.

9. Plasmareaktor nach Anspruch 7, worin der Gaseinlass (10a) und der Gasauslass (10b) des Plasmareaktionsabschnitts in einer Richtung im rechten Winkel auf die Stapelrichtung an einer Endfläche des Plasmareaktors ausgebildet sind.

10. Plasmareaktor nach Anspruch 6, worin:

der Gaseinlass (10a) des Plasmareaktionsabschnitts (10) und der Gasauslass (20b) des Wärmezufuhrgaszirkulationsabschnitts (20) in einer Richtung im rechten Winkel auf die Stapelrichtung an einer Endfläche des Plasmareaktors ausgebildet sind;
der Gasauslass (10b) des Plasmareaktionsabschnitts (10) und der Gaseinlass (20a) des Wärmezufuhrgaszirkulationsabschnitts (20) in einer Richtung im rechten Winkel auf die Stapelrichtung an der anderen Endfläche des Plasmareaktors ausgebildet sind; und
der Gaseinlass (10a) des Plasmareaktionsabschnitts und der Gaseinlass (20a) des Wärmezufuhrgaszirkulationsabschnitts an entgegengesetzten Positionen ausgebildet sind und der Gasauslass (10b) des Plasmareaktionsabschnitts und der Gasauslass (20b) des Wärmezufuhrgaszirkulationsabschnitts an entgegengesetzten Positionen ausgebildet sind.

11. Plasmareaktor nach einem der Ansprüche 1 bis 10, worin eine Vielzahl der Plasmareaktionsabschnitte (10) und eine Vielzahl der Wärmezufuhrgaszirkulationsabschnitte (20) abwechselnd und einstückig übereinandergestapelt sind.

12. Plasmareaktor nach Anspruch 6, worin:

ein Gaseinleitungs-/-zirkulationsabschnitt (21) an einer Seite einer Flachelektrode des Flachelektrodenpaares (2) einer Öffnung zwischen dem Flachelektrodenpaar gegenüberliegend bereitgestellt ist, wobei das erste Gas in den Gaseinleitungs-/-zirkulationsabschnitt (21) eingeleitet und in diesem zirkuliert wird;
eine Vielzahl von Durchgangslöchern (15) in dem Flachelektroden (2) ausgebildet ist, wobei die Durchgangslöcher (15) von einer dem Gaseinleitungs-/- zirkulationsabschnitt (21) zugewandten Seite der Flachelektrode (2) bis zu einer der Öffnung zugewandten Seite der Flachelektrode ausgebildet sind;
jedes der Durchgangslöcher in einem Bereich eines in dem Leiter (3) ausgebildeten Leiterdurchgangslochs (3h) ausgebildet ist und einen geringeren Durchmesser als das Leiterdurchgangsloch (3h) aufweist; und das erste Gas durch den Gaseinleitungs-/-zirkulationsabschnitt (21) und die Durchgangslöcher (15) in einen Raum zwischen dem Flachelektrodenpaar eingeleitet wird und eine Spannung zwischen das Flachelektrodenpaar (2) angelegt wird, um in dem Entladungsabschnitt zwischen dem Flachelektrodenpaar Plasma zu erzeugen.

13. Plasmareaktor nach Anspruch 12, worin der Wärmezufuhrgaszirkulationsabschnitt (20), der die Zirkulation eines zweiten Gases ermöglicht, an eine dem Plasmareaktionsabschnitt (10) entgegengesetzte Seite des Gaseinleitungs-/-zirkulationsabschnitts (21) angrenzend und einstückig mit diesem aufgestapelt ist.

14. Plasmareaktor nach einem der Ansprüche 1 bis 13, worin der Leiter (3), der in dem Keramikdielektrikum eingebettet ist, sich von einer Endfläche der Flachelektrode erstreckt und mit einem Anschluss (5) verbunden ist, wobei der Anschluss einstückig aus einer Vielzahl von Flachelektroden (2) ausgebildet ist.

15. Plasmareaktionsvorrichtung, die einen Plasmareaktor nach einem der Ansprüche 1 bis 14 und eine Impulsspannungsversorgung (31) umfasst, die die Steuerung der Dauer eines Impulshalbwerts auf 1 ms oder weniger ermöglicht.

**Revendications**

1. Réacteur à plasma comprenant :

   une section de réaction à plasma (10) qui comprend une paire d'électrodes tabulaires (2) se faisant face dotée d'une ouverture et génère du plasma dans une section de décharge (11) entre la paire d'électrodes tabulaires (2) lors de l'application d'une tension entre la paire d'électrodes tabulaires de telle sorte qu'un premier gaz qui traverse la section de décharge (11) soit soumis à une réaction, chacune de la paire d'électrodes tabulaires (2) comprenant un diélectrique céramique (4) et un conducteur (3) encastré dans le diélectrique céramique ; **caractérisé par** :

   une section de circulation des gaz fournissant de la chaleur (20) qui est empilée de manière adjacente à la section de réaction à plasma (10) et est formée solidairement avec la section de réaction à plasma, la section de circulation des gaz fournissant de la chaleur (20) appliquant de la chaleur à un second gaz, ladite chaleur traversant la section de réaction à plasma (10) pour favoriser la réaction du premier gaz.

2. Réacteur à plasma selon la revendication 1, dans lequel un catalyseur est supporté sur une surface de génération de plasma de l'électrode tabulaire (2).

3. Réacteur à plasma selon la revendication 1 ou 2, dans lequel un catalyseur est supporté sur un côté de la section de circulation des gaz fournissant de la chaleur (20) qui vient en contact avec le gaz qui circule dans la section de circulation des gaz fournissant de la chaleur (20).

4. Réacteur à plasma selon l'une quelconque des revendications 1 à 3, dans lequel le catalyseur est une substance qui contient au moins un élément choisi dans le groupe constitué d'un métal précieux, d'aluminium, de nickel, de zirconium, de titane, de cérium, de cobalt, de manganèse, de zinc, de cuivre, d'étain, de fer, de niobium, de magnésium, de lanthane, de samarium, de bismuth et de baryum.

5. Réacteur à plasma selon la revendication 4, dans lequel le métal précieux est une substance qui contient au moins un élément choisi dans le groupe constitué de platine, de rhodium, de palladium, de ruthénium, d'indium, d'argent et d'or.

6. Réacteur à plasma selon l'une quelconque des revendications 1 à 5, dans lequel un orifice d'admission des gaz (10a) et un orifice de sortie des gaz (10b) de la section de réaction à plasma (10) et un orifice d'admission des gaz (20a) et un orifice de sortie des gaz (20b) de la section de circulation des gaz fournissant de la chaleur (20) sont formés de telle sorte qu'une première direction de circulation des gaz et une seconde direction de circulation des gaz soient formées perpendiculairement à une direction d'empilement de la section de réaction à plasma et de la section de circulation des gaz fournissant de la chaleur.

7. Réacteur à plasma selon la revendication 6, dans lequel un premier trajet de circulation des gaz et un second trajet de circulation des gaz de la section de réaction à plasma (10) sont formés de telle sorte que la première direction de circulation des gaz de la section de réaction à plasma soit perpendiculaire à la seconde direction de circulation des gaz de la section de circulation des gaz fournissant de la chaleur (20).

8. Réacteur à plasma selon la revendication 7, dans lequel l'orifice d'admission des gaz (10a) et l'orifice de sortie des gaz (10b) de la section de réaction à plasma sont formés sur une face d'extrémité et l'autre face d'extrémité du réacteur à plasma dans une direction perpendiculaire à la direction d'empilement.

9. Réacteur à plasma selon la revendication 7, dans lequel l'orifice d'admission des gaz (10a) et l'orifice de sortie des gaz (10b) de la section de réaction à plasma sont formés sur une face d'extrémité du réacteur à plasma dans une direction perpendiculaire à la direction d'empilement.

10. Réacteur à plasma selon la revendication 6, dans lequel :

l'orifice d'admission des gaz (10a) de la section de réaction à plasma (10) et l'orifice de sortie des gaz (20b) de la section de circulation des gaz fournissant de la chaleur (20) sont formés sur une face d'extrémité du réacteur à plasma dans une direction perpendiculaire à la direction d'empilement ;
l'orifice de sortie des gaz (10b) de la section de réaction à plasma (10) et l'orifice d'admission des gaz (20a) de la section de circulation des gaz fournissant de la chaleur (20) sont formés sur l'autre face d'extrémité du réacteur à plasma dans la direction perpendiculaire à la direction d'empilement ; et
l'orifice d'admission des gaz (10a) de la section de réaction à plasma et l'orifice d'admission des gaz (20a) de la section de circulation des gaz fournissant de la chaleur (20) sont formés à des positions opposées et l'orifice de sortie des gaz (10b) de la section de réaction à plasma et l'orifice de sortie des gaz (20b) de la section de circulation des gaz fournissant de la chaleur sont formés sur des positions opposées.

11. Réacteur à plasma selon l'une quelconque des revendications 1 à 10, dans lequel une pluralité des sections de réaction à plasma (10) et une pluralité des sections de circulation des gaz fournissant de la chaleur (20) sont empilées en alternance et de manière solidaire.

12. Réacteur à plasma selon la revendication 6, dans lequel :

une section d'introduction/de circulation des gaz (21) est dotée sur un côté de l'une de la paire d'électrodes tabulaires (2) opposée à une ouverture entre la paire d'électrodes tabulaires, le premier gaz étant introduit dans la section d'introduction/de circulation des gaz (21) et circulant à l'intérieur ;
une pluralité de trous traversants (15) sont formés dans l'électrode tabulaire (2), les trous traversants (15) étant formés depuis d'un côté de l'électrode tabulaire (2) qui est orientée vers la section d'introduction/de circulation des gaz (21) d'un côté de l'électrode tabulaire qui est orientée vers l'ouverture ;
chacun des trous traversants est formé dans une zone d'un trou traversant de conducteur (3h) formé dans le conducteur (3) et a un diamètre inférieur à celui du trou traversant de conducteur (3h) ; et
le premier gaz est introduit dans un espace entre la paire d'électrodes tabulaires à travers la section d'introduction/de circulation des gaz (21) et les trous traversants (15) et une tension est appliquée entre la paire d'électrodes tabulaires (2) pour générer du plasma dans la section de décharge entre la paire d'électrodes tabulaires.

13. Réacteur à plasma selon la revendication 12, dans lequel la section de circulation des gaz fournissant de la chaleur (20) qui permet au second gaz de circuler est empilée de manière solidaire et adjacente d'un côté de la section d'introduction/de circulation des gaz (21) opposé à la section de réaction à plasma (10).

14. Réacteur à plasma selon l'une quelconque des revendications 1 à 13, dans lequel le conducteur (3) encastré dans le diélectrique céramique s'étend vers une face d'extrémité de l'électrode tabulaire et est connecté à une borne (5), la borne étant formée de manière solidaire correspondant à une pluralité d'électrodes tabulaires (2).

15. Appareil de réaction à plasma comprenant le réacteur à plasma selon l'une quelconque des revendications 1 à 14, et une alimentation électrique par impulsions (31) qui permet à une largeur de demi-absorption d'impulsion d'être contrôlée à 1 microseconde près ou moins.

FIG. 1

H2 REFORMED GAS

1

5

EXHAUST GAS
(SECOND GAS)

20b

FUEL-CONTAINING GAS   10a          5
(FIRST GAS)

FIG.2

2(2a)

3

5

5

2(2b)

3

EXHAUST GAS
(SECOND GAS)

5

2(2b)

5a

3

20a

20b

10b

2(2a)

3

10a

5

FUEL-CONTAINING GAS(FIRST GAS)

FIG.3

EXHAUST GAS

FIG.4

EXHAUST GAS
(SECOND GAS)

FUEL-CONTAINING GAS(FIRST GAS)

FIG.5

5

5

FUEL-CONTAINING GAS
(FIRST GAS)

10a

H2 REFORMED GAS

10b

EXHAUST GAS(SECOND GAS) 20a

FIG.6

FUEL-CONTAINING GAS
(FIRST GAS)

H₂ REFORMED GAS

EXHAUST GAS(SECOND GAS)

FIG.7

EXHAUST GAS(SECOND GAS)  H₂ REFORMED GAS

5

10a

20b

FUEL-CONTAINING GAS(FIRST GAS)

## FIG.8

FIG.9

5(5a)

10{

NON-DISCHARGE STAGE(HEAT-SUPPLYING
GAS CIRCULATION SECTION)

}20

10{

DISCHARGE STAGE(PLASMA REACTION
SECTION)

5(5b)

}20

10{

}20

10{

4  3
2

FIG.10

EXHAUST GAS
(SECOND GAS)

20a

INTRODUCES FIRST GAS

10a

5a

5

7

4 3

2(2a)

17

17

7

5

5a

3

4

2(2b)

10b

DISCHARGES FIRST GAS

EXHAUST GAS
(SECOND GAS)

20a

7

20b

9

7

20b

7

7

**FIG.11A**

**FIG.11B**

GAS CIRCULATION DIRECTION

**FIG.12**

**EP 2 091 305 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006265008 A
- US 7131264 B
- US 7240483 B
- US 20070221633 A